(19) Europäisches Patentamt
European Patent Office
Office européen des brevets

(11) **EP 4 145 224 A1**

(12) **EUROPEAN PATENT APPLICATION**

(43) Date of publication:
**08.03.2023 Bulletin 2023/10**

(21) Application number: **21194755.1**

(22) Date of filing: **03.09.2021**

(51) International Patent Classification (IPC):
**G03F 7/039** *(2006.01)*     **G03F 7/32** *(2006.01)*

(52) Cooperative Patent Classification (CPC):
**G03F 7/325; G03F 7/039; G03F 7/2014;
G03F 7/2018; G03F 7/38; G03F 7/40**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Universiteit Maastricht
6211 LK Maastricht (NL)**
• **Academisch Ziekenhuis Maastricht
6229 HX Maastricht (NL)**

(72) Inventors:
• **SAMAL, Pinak
MAASTRICHT (NL)**
• **TRUCKENMÜLLER, Roman
MAASTRICHT (NL)**
• **GISELBRECHT, Stefan
MAASTRICHT (NL)**

(74) Representative: **Algemeen Octrooi- en
Merkenbureau B.V.
P.O. Box 645
5600 AP Eindhoven (NL)**

(54) **DEEP UV LITHOGRAPHY OF POLYSTYRENE SUBSTRATES**

(57)    The present invention relates to a method for producing structures in a polystyrene substrate, which substrate may for example be used for cell culturing. The inventive method comprising the steps of: a) providing a polystyrene substrate having a surface; b) partially exposing the surface of said polystyrene substrate to deep ultraviolet light radiation having a wavelength of 100 nm - 300 nm to selectively photodegrade polystyrene at the surface of the exposed areas; and c) removing the degraded polystyrene from the surface of the exposed areas by wet chemical development using a chemical developer solution comprising an organic solvent in an alcohol in an amount of 1:10 to 1:1 to produce said structures. The invention is also related to a polystyrene substrate having a structured surface thus obtained as well as to a method of treating a surface of a polystyrene substrate by deep UV lithography.

Fig. 1

**Description**

**TECHNICAL FIELD**

The present invention relates to a method for producing structures in a polystyrene substrate and a structured polystyrene substrate obtained therewith. The present invention relates to polystyrene lithography and provides a facile method for structuring polystyrene substrates.

**BACKGROUND**

Microengineering is currently playing a crucial part in further advancing of both 2D and 3D cell cultures. Microengineering enables the creation of more instructive environments for cells including defined topographies, microfluidic flows or mechanical forces, for instance. Even with these obvious advantages, micro engineered platforms have not been widely adopted for cell biology mostly due to the underlying use of specialized equipment, absence of simplified methods and the poor performance of some of the materials used in biomedical applications.

Microengineering techniques are used to create advanced cell microenvironments in polystyrene requiring specialized equipment as well as reagents. Polystyrene substrates are the gold standard for in vitro cell culture because of its biocompatibility, optical transparency, easy processability and low costs. Common ways that are known to provide structures/patterns into polystyrene include hot embossing and micro-drilling using UV-laser ablation. These special requirements hinder the accessibility of this method for most biological researchers. Palacios et al., Langmuir 2013, 29, pages 2756-2763, titled: "*Constructing Robust and Functional Micropatterns on Polystyrene Surfaces by Using Deep UV Irradiation*", discloses a dual use of UV radiation to prepare structures in spin-coated polystyrene coatings. Palacios first prepares a spin-coated coating that is up to a few hundreds of nanometer thick of polystyrene on substrates from THF solutions thereof. In a following step Palacios uses UV to make surface patterns; UV radiation is used to cross-link polystyrene and solidify it - any non-crosslinked polystyrene and any degraded polystyrene is rinsed off using THF.

Disadvantages of these methods is that they are cumbersome, require specialized equipment and/or (corrosive) reagents or - in the case of Palacios - are only applicable on specially prepared thin polystyrene coatings.

Despite the widespread use of polystyrene, a facile and flexible microengineering method using it, without the need for specialized, costly equipment and expert personnel, has not been available so far. Such a new method would extend the toolbox of cell biologists and could further help to bioengineer functional environments in a well-trusted and characterized material, thus bridging the gap between microengineering and biological applications.

**SUMMARY**

It is an object of the present invention to provide a method of structuring the surface of polystyrene substrates. In particular, it is an object of the present invention to provide an economical and easily accessible method for fabricating structures directly in polystyrene substrates with feature sizes approaching subcellular dimensions while requiring minimal processing time.

The present invention provides in a first aspect a method for producing structures in a polystyrene substrate, said method comprising the steps of: a) providing a polystyrene substrate having a surface; b) partially exposing the surface of said polystyrene substrate to deep ultraviolet light radiation having a wavelength of 100 nm - 300 nm to selectively photodegrade polystyrene at the surface of the exposed areas; and c) removing the degraded polystyrene from the surface of the exposed areas by wet chemical development using a chemical developer solution comprising an organic solvent in an alcohol in an amount of 1:10 to 1:1 to produce said structures.

The present invention provides in a second aspect a polystyrene substrate having a structured surface directly obtained or obtainable by the method according to the invention.

Corresponding embodiments for the method of the first aspect are also applicable for the substrate of the second aspect according to the present invention.

**LIST OF DEFINITIONS**

The following definitions are used in the present description and claims to define the stated subject matter. Other terms not cited below are meant to have the generally accepted meaning in the field.

"Structures" as used in the present description means: a part of a surface that is raised and/or depressed in a particular arrangement. "Microstructures" as used in the present description means: structures having dimensions in the micrometer range. "Nanostructures" as used in the present description means: structures having dimensions in the nanometer range. With producing structures in a polystyrene substrate is meant producing structures in or on a substrate.

"Patterns" as used in the present description means: structures that are arranged in a regular manner. "Micropatterns" as used in the present description means: patterns having dimensions in the micrometer range. "Nanopatterns" as used in the present description means: patterns having dimensions in the nanometer range.

"Polystyrene substrate" as used in the present description means: a solid object or support made of polystyrene that serves as the basis for structuring according to the present invention.

"Surface" as used in the present description means: the surface of the polystyrene substrate on to which the structures are provided, e.g. the surface of cell culture ware, the surface of a polystyrene film.

"Expose" or "exposing" as used in the present description means: to subject (the substrate) to radiant energy.

"Exposed area" as used in the present description means: the surface that is exposed to radiant energy. "Partially exposing" as used in the present description means: to expose only part of the surface, the part that is exposed to radiant energy is selectively degraded and will, after the developing step of the present method, have a decreased height. This can be the part that underlies the transparent part of a mask, or the part that is not provided with toner/ink.

"Deep ultraviolet light" or "deep UV" or "DUV" or "UVC" as used in the present description means: radiant energy having a wavelength in the range of deep ultraviolet light. According to the present invention, that wavelength is between 100 and 300 nm, preferably between 200 and 280 nm.

"Selectively photodegrade polystyrene" as used in the present description means: the action of the radiant energy will provide a complex combination of chain scission processes, cross-linking processes and photooxidation processes by which polystyrene at the surface will be degraded after which it can be removed by wet chemical development.

"Wet chemical development" or "chemical development" as used in the present description means: the chemical process in which the surface polystyrene substrate is treated with a developer solution that will transfer a latent image provided by the selective photodegradation into visible structures by removing the degraded polystyrene from the exposed surface of the polystyrene substrate.

"Developer" or "chemical developer" or "developer solution" or "chemical developer solution" as used in the present description means: a mixture of an organic solvent and an alcohol that is used to remove (by dissolving or dispersing) the degraded polystyrene from the polystyrene surface.

"Organic solvent" as used in the present description means: carbon-based substance used in the developer solution that is capable of dissolving or dispersing the degraded polystyrene.

"Alcohol" as used in the present description means: an organic compound that carries at least one hydroxyl functional group (-OH) bound to a saturated carbon atom.

"Thickness" as used in the present description means: the distance between either the top and bottom or front and back surfaces of the polystyrene substrate, polystyrene film or polystyrene coating.

"Solid self-supporting material" as used in the present description means: a material that staying up(right) without being supported by something else. This is in contrast to a coating on a substrate, which coating as such is not a self-supporting material, in general in the case of polystyrene, the substrate has a thickness of at least 1 $\mu$m to form a solid self-supporting material. The self-supporting material may for example be a polystyrene film or a cell culture ware.

"Polystyrene film" as used in the present description means: polystyrene material in the form of a thin flexible sheet, in general having a thickness of between 1 $\mu$m and 500 $\mu$m.

"Polystyrene coating" as used in the present description means: a thin layer of polystyrene that is provided on the surface of a substrate (that may or may not be polystyrene), in general a coating will have a thickness of between 1 nm and 1000 nm.

"Cell culture ware" as used in the present description means: polystyrene products/objects that are used in cell culture. Other words are "cell culture plastics" or "cell culture plastic ware". These are staple items in biological laboratories and include e.g. cell culture flasks, cell culture dishes (e.g. Petri dishes), multi-well plates or microtiter plates. These ware may be tissue culture treated or non-treated. With treated is meant a treatment with an ionized gas (so-called corona treatment) that is carried out by manufactures of said ware to produce surface modifications that make the surface more polar or charged which supports cell attachment.

"Photomask" as used in the present description means: a combination of opaque/absorbing/non-transparent regions and non-absorbing/transparent regions that is applied to the surface of the substrate. Photomasks are commonly used in photolithography and are used to produce a pattern on the substrate. The photomask may be a plate of a flexible carrier having holes or transparencies that allow UV light to shine through. In the present invention, the photomask may be a shadow photomask with non-absorbing and absorbing regions, a Chromium-quartz (CQ) photomask, an ink and/or a toner photomask, in the latter ink and/or toner is applied to the surface of the substrate either directly, e.g. by direct printing or by writing with a permanent marker pen, or indirectly, e.g. transferred from a printed image on a flexible substrate.

"Depth" or "height" as used in the present description means: the difference in height between the parts of the polystyrene surface that have been exposed to radiation and development and that have not. These structures can be seen in two ways, either they are so-called raised structures or they are depressed structures. In case of raised structures, the polystyrene in between has been removed by the present method. In this case, the photomask used was absorbent/non-transparent at the position of the structures; the structures themselves were not exposed to radiation but the surrounding area was. In case of depressed structures, the polystyrene at the position of the structures is removed. In this case, the photomask used was non-absorbent/transparent at the position of the structures; the structures themselves were exposed to radiation and the surrounding area was not and remained their original height. With raised structures, the inventors speak of height (the height is expressed here as the difference between the upper surface of the structures and the "bottom" of the surrounding area. With depressed structures, the inventors speak of depth, being the difference between the upper surface of the remaining areas and the "bottom" of the structures.

"Width" as used in the present description means: the width of the structures. A structure has a width and a length (both parallel to the surface) and a depth or height that is perpendicular to the surface. In case the width and the length are not the same, the longer of the two is considered the length and the shorter the width.

"Thermoforming" or "microthermoforming" as used in the present description means: the process in which a flexible polystyrene film is shaped into a three-dimensional (3D) object using heat and pressure to form the object.

"Ambient conditions of temperature, pressure and humidity" as used in the present description means: conditions of ambient temperature, ambient pressure, and ambient humidity. With ambient is meant as present in the surroundings.

"Ambient temperature" as used in the present description means: room temperature or the temperature at the location the method is used, without using equipment to control the temperature. Depending on the location room temperature may vary significantly but according to Oxford English Dictionary it is conventionally taken as about 20 °C.

"Ambient pressure" as used in the present description means: room pressure or the pressure at the location the method is used, without using equipment to control the pressure; it is also called atmospheric pressure or barometric pressure. For sea level it is approximately 1 atm, being 101,325 Pa.

"Ambient humidity" as used in the present description means: room humidity or the humidity at the location the method is used, without using equipment to control the humidity. Ambient humidity may vary significantly from location to location, since it also depends on the temperature.

"Power of radiation" as used in the present description means: the power density or intensity of radiation energy (electromagnetic radiation). The unit used is milliwatt per square centimeter ($mW/cm^2$). Milliwatt is the same as millijoule per second (mJ/sec).

"Radiation dosage" as used in the present description means: the total amount of radiation energy per surface unit. It is the product of the power of radiation and the exposure time. The unit is either $mJ/cm^2$ or $J/cm^2$.

## BRIEF DESCRIPTION OF DRAWINGS

The present invention is described hereinafter with reference to the accompanying drawings in which embodiments of the present invention are shown and in which like reference numbers indicate the same or similar elements.

Figure 1A and B show schematic illustrations of the present method in which microstructures are directly produced in cell culture ware. Figures 1C-E show the fabricated structures.
Figure 2 (A-C) shows the fabrication of patterns using office printers.
Figure 3 (A-B) show the fabrication of structures using a pocket DUV source.
Figure 4 (A-E) show how different patterns are structured into different types of plates.
Figure 5 (A-C) shows the preparation of microstructures using a permanent ink pen.
Figure 6 (A-D) shows the results of UV measurements on the effect of the time of exposure and development.
Figure 7 shows the effect of increasing the DUV exposure time on the surface roughness.
Figure 8 (A-E) shows that the structures may be used to control and manipulate cell migration, orientation and outgrowth.

## DESCRIPTION OF EMBODIMENTS

The first aspect of the present invention relates to a method for producing structures in a polystyrene substrate according to claim 1. The present method involves direct UV lithography using deep ultraviolet radiation to selectively degrade polystyrene at the surface of a substrate to provide structures in said substrate. The method can be carried out using inexpensive, optionally even handheld, radiation devices that are present in each laboratory, which irradiation step is followed by selective chemical development with common reagents to generate structures in polystyrene.

This method is straightforward and uses such common materials that it can be carried out in every biological laboratory using material they have on site. It even allows this method to be broadly accessible to diverse research communities throughout the world, even in less developed countries. The present method directly creates structures in polystyrene substrate, preferably commercially available polystyrene substrate, and hence does not require the need to first prepare specialized polystyrene substrates.

Without wishing to be bound by a particular theory, the present inventors believe that photodegradation of polystyrene occurs due to a complex combination of chain scission processes, cross-linking processes and photooxidation processes. The kinetics of these different processes are usually dependent on a variety of factors including the irradiation dose, availability of oxygen and presence of a photo-initiator. Since these factors can be difficult to control and replicate in a laboratory, the present method was found to overcome these challenges by using ambient conditions and no photo-initiator. In an embodiment, no photo-initiator is used in the present method.

As will be discussed in more detail in the Examples, the present inventors have found dose-dependent photodegradation upon DUV exposure which confirmed using UV-VIS spectroscopy. The photodegradation was found to be accompanied by progressive increase in yellowing and autofluorescence with increasing radiation dosage, which yellowing and autofluorescence was found by the inventors to be decreased significantly after the wet chemical development without any significant increase in surface roughness of the treated substrates.

The influence of the topography of a surface onto which cells are cultures is known to exhibit effects on the way cells grow, these surface topographical cues can influence the morphology as well as migratory behavior of cells, such as neurons and the differentiation in multiple cell types. Examples of structures/patterns that can be prepared using the present methods include, complex micropatterns or nanopatterns including grids, parallel microgrooves or other surface topographical cues, freestanding round or square "pillars" (e.g. ranging from 5 to 10 $\mu$m in height) as well as alphanumeric entities. This nanometer- or micrometer-sized topography provides spatial constraints promoting different morphology and/or migratory behavior in cells. These mimic similar behavior that is found in vivo, e.g. in embryonic neuron development. These structures substrates can therefore be used to study growth of embryonic cells.

The present inventors have shown that microgrooves of different dimensions can be prepared in polystyrene culture ware and that these are able to control single-cell behavior. The results are shown in the Examples. Furthermore, tests were carried out to study the use of structures to guide outgrowth in 3D multicellular spheroids, usually requiring prepatterned biochemical gradients. The present inventors have observed that the method according to the present invention does not affect the cell viability and cell growth nor the autofluorescence. These are important parameters when the structured substrates are used for cell growth.

The structures that are provided in the substrate may be used for several different purposes. An example is fabricating cell counting grids that appear in the light path without influencing cell culture. An example is the use of a structured substrate to guide cell (growth) behavior in cell culture techniques or to seed and culture cells, on-chip staining and imaging. A variety of biomedical applications may be considered by influencing cell attachment in micropatterns, creating artificial cell patterns and enabling high-throughput studies utilizing libraries of multiple micropatterns in the same dish or well. The resulting microstructures could also be potentially coupled to soft lithography using DUV-lithographically created polystyrene masters. The presented method could be used with a combination of topographical patterning and patterning of cell adhesiveness in non-tissue culture-treated polystyrene dishes based on the same type of DUV light source. Other applications include the fabrication of optical systems, biomedical equipment and food packaging.

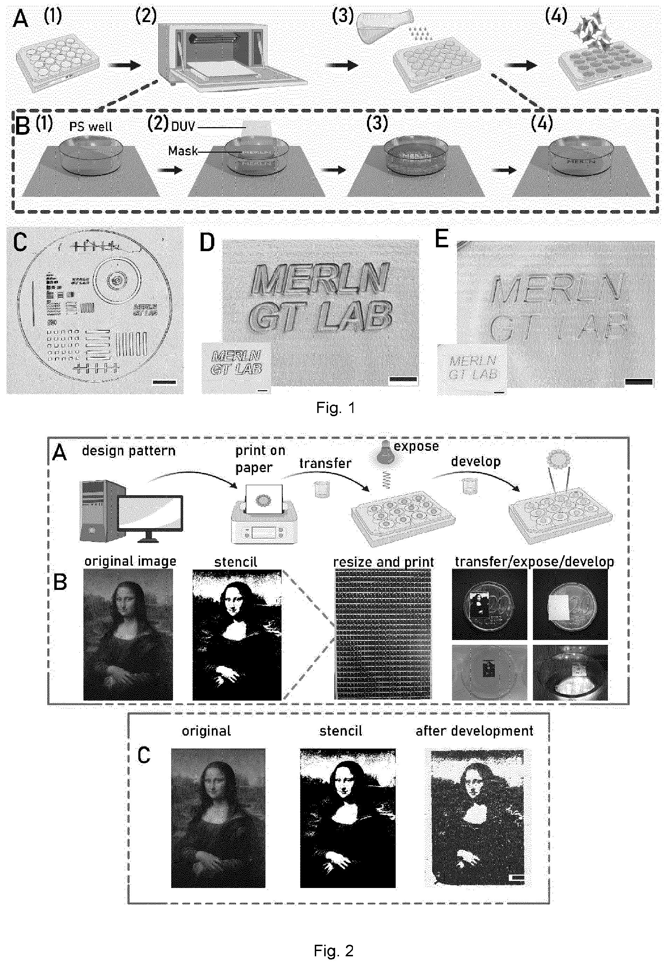

Figure 1A shows microstructure fabrication on cell culture ware in a schematic way. The most left picture shows a multi well plate, the second picture shows the exposure of the surface of the wells in these plate to deep UV, the third picture shows the chemical development and the most right hand picture shows that the micropatterned substrate is ready for cell seeding.

Figure 1B shows a more detailed schematic view showing an enlarged picture of one well in a 6-well plate and in the second picture the provision of a mask; the third picture shows the structure after deep UV irradiation and the fourth shows the microstructures after development.

In an embodiment, the organic solvent of the developer solution is selected from the group consisting of xylene, acetone, toluene, dimethyl sulfoxide, and dichloromethane. The inventors have observed that these are optimally capable of removing the degraded styrene (by dissolution or dispersion). Preferably, the organic solvent is xylene, which according to the inventors have provided optimal results. In an embodiment, the alcohol in the developer solution is isopropyl alcohol (IPA). This alcohol, especially in combination with xylene, has provided optimal results.

In an embodiment, a polystyrene substrate is used having a thickness of at least 1 micrometer. The thickness ensures that the polystyrene can be used without the need for a separate supporting material. The substrate is preferably a solid self-supporting material or a polystyrene film. The polystyrene substrates as used in the present method require no preprocessing and have a long shelf life. There is no requirement of a cross-linking step nor is the crosslinking dependent on the DUV irradiation.

In an embodiment, the substrate is a polystyrene coating having a thickness of between 1 and 1000 nm on a substrate. For specific applications this can be useful although it is preferred to have a self-supporting material.

In an embodiment, as a substrate polystyrene cell culture ware is used, preferably selected from the group consisting of a Petri dish, a tissue culture treated or non-treated multi-well cell culture plate, and a microtiter plate. The whole process can thus be performed directly in polystyrene cell culture ware, which circumvents the need to obtain and optimize polystyrene from different sources while simplifying the cell culture and imaging process. By the present method, the famous and ubiquitously used polystyrene Petri dishes, can be transformed into the next generation "Petri dish 2.0" with more distinct and detailed microenvironments.

In an embodiment, step b) comprising the following sub steps: b-1) applying a photomask to the surface of the polystyrene substrate to be structured; b-2) exposing the surface of said polystyrene substrate through said photomask to deep ultraviolet light having a wavelength of 100 nm - 300 nm to selectively degrade polystyrene at the surface of the exposed areas; b-3) removing of said photomask from said exposed surface of the polystyrene substrate. The irradiation causes selective photodegradation at the areas of the substrate corresponding to the areas of the photomask that are non-absorbent/transparent to the irradiation use so that the radiation reaches the surface beneath the mask. The absorbent/non-transparent parts of the mask will not allow UV light to pass through and these sections are not degraded and hence remain untouched. This combination of absorbent and non-absorbent regions on the photomask will provide the structures.

In an embodiment, the photomask is selected from the group consisting of a shadow photomask with non-absorbing and absorbing regions, a Chromium-quartz (CQ) photomask, and an ink photomask. The present method may be carried out using conventional photolithography masks, such as CQ masks. However, they may be challenging for biological laboratories owing to requirements concerning specialized design software, outsourcing of the mask fabrication and consequent temporal delays for obtaining these masks. To circumvent the dependence on conventional masks, the present inventors also devised approaches that enable selective exposure of polystyrene substrates DUV using an ink photomask, that may be obtained via ink and/or toner transfer from a printed flexible substrate to the polystyrene substrate to be structured or by simply writing on the polystyrene substrate to be structures using a permanent marker pen. The Examples show explanation of each of these. The use of a marker pen is possible but has a somewhat low reproducibility and the size of the structures obtained are limited to the marker tip size (-750 $\mu$m); this method is suitable but cannot be used for creating complex patterns. A marker pen contain a complex ink solution comprising a coloring agent, solvents and binders, showing absorbance in DUV range. Normal photopaper can have sharp, rough spots on the surface of the paper which become visible on the substrate after development. To circumvent this, the patterns may be printed on backing paper. The patterns were then imprinted onto the substrate. Unlike photopaper, the use of backing paper prevented the formation of spots in the unexposed regions and led to visibly improved pattern reproduction after development.

Figure 2 shows the fabrication of patterns using office printers. Figure 2A schematically shows the use of an office printer for offset printing of complex patterns onto a flexible substrate (e.g. paper) and then transferring that to the polystyrene substrates for use as a mask. Figure 2B shows a workflow showing the conversion of complex patterns to imprinted masks where an image (Mona Lisa) was digitally processed (stencil, middle left) followed by resizing, mirroring the pattern and printing (middle right). The resulting pattern on paper is shown before (left, top row) and after imprinting (right, top row) the pattern onto the substrate before (left, bottom row) and after development (right, bottom row). Figure 2C shows (left to right) the original photo of a pattern, the stencil thereof, and after development. Scale bars represent 1000 $\mu$m.

In an embodiment using a lithography chromium-quartz (CQ) mask with either positive or negative tone of one and the same patterns, the present inventors achieved the fabrication of either raised or embedded/engraved features approaching as low as 2 $\mu$m in feature size, some already after a very short period (e.g. 30 seconds) of wet chemical development.

In an embodiment, the ink photomask is prepared using a printed flexible substrate, such as paper or polymer film or backing paper, e.g. for printing labels or stickers. This printed substrate may be prepared by a standard office printer, such as a laser printer or an inkjet printer that is present in any laboratory. In an embodiment, the photomask is an ink photomask prepared by transferring toner and/or ink from a printed surface to the surface to be structured.

Printing directly onto the polystyrene substrate can be used according to the present invention, e.g. for polystyrene films. However, for solid self-supporting material, preferably cell culture ware, it is challenging because the substrates are several millimeters in thickness, which makes them inflexible and non-compatible with the printers. In addition, the fuse roller temperature in office laser printers can range between 130 and 210 °C, which is significantly higher than the glass transition temperature of polystyrene leading to possible deformation of the surface of the polystyrene substrate. To circumvent these issues, the present inventors have observed that when offset printing is used, toner and/or ink can be transferred from printed flexible substrates (e.g. printed paper) to the surface of the polystyrene substrates using the developer solution (organic solvent in alcohol) followed by the present photolithography method to generate structures. This process is also compatible with the portable UVC-LED box described below. The use of backing paper consisting of a silicone coating, on which labelling stickers used in biological laboratories are often supplied, resulted in improved pattern reproduction by reducing surface imperfections present on photopaper. The patterns were well-reproduced after the toner transfer, exposure and subsequent development as observed in the optical and height-map images. A major advantage of using an automated printing process is the ability to fabricate different patterns from a variety of sources including high-definition photos, vector graphics and microscopy images right at the site of the laboratory. Software such as Blender can be used to "virtualize" the lithography process using physically based path-tracing/rendering and create height maps that closely resemble the final micro-engineered patterns.

In an embodiment, step c) comprises the sub steps of: c-1) applying the chemical developer to said surface of said substrate, said developer preferably being xylene in IPA (ratio of 1:10 - 1:1, preferably 1:3) to remove degraded polystyrene; and c-2) rinsing said surface of said substrate provided with structures a solvent, preferably IPA, to clean said surface. The present inventors have observed that with this developer they were able to effectively remove degraded polystyrene from the substrate without effecting other parts of the substrate so that a clean and correct structure is obtained that corresponds to the mask that is used. The irradiation is followed by selective dissolution of the degraded polymer using a developer solution. In a preferred embodiment, the developer solution comprises a mixture of xylene in isopropyl alcohol (IPA), such as in a 1:3 ratio. This solution is commonly used in most histology and molecular biology laboratories. In addition, this solution comprises only reagents that are compatible with cells and after which no specific steps are required to ensure that the structure substrate can be used for the desired applications.

In an embodiment, the exposure of step b) is carried out for 10 to 500 minutes. In an embodiment, the development of step c) is carried out from 1 to 1000 seconds, such as from 10 to 750 seconds. In an embodiment these two previous embodiments are combined. Depending on the depth requirements, the whole process could thus be performed within an hour.

In an embodiment, the structures formed are nanostructures and/or microstructures, preferably having a width no less than 100 nanometer and/or preferably the structures formed have a depth from 1 to 20 micrometer. In an embodiment, the structures formed have a depth (which may also be called height) from 1 to 20 micrometer, such as from 4 to 15 micrometer, such as from 5 to 10 micrometer. Structures with these dimensions affect cell behavior at a (sub)cellular resolution.

In an embodiment, as a substrate a polystyrene film is used and wherein an additional step d) is present, comprising the (micro)thermoforming of said structured polystyrene film. The additional step d), can be carried out after step c) or in between of step b) and step c). This (micro)thermoforming allows the preparing of 3D structured surfaces and patterned curvilinear surfaces. In an embodiment, the present inventors have prepared patterned curvilinear surfaces, which 3D patterned surfaces can be used to provide defined topographical guidance for monolayers or microtissues in microwells. The present inventors have used thin pre-processed polystyrene films and structured them according to the method of the invention, after which they were microthermoformed to, for example, form 3D micropatterned microcavities. The microthermoforming may be carried out prior or after the step of wet chemical development. This inventive method produced patterned curvilinear surfaces with microgrooved structures extending across the dimension of the cavity.

In an embodiment, the method is carried out at ambient conditions of temperature and pressure (and humidity). The present method is not dependent on temperature- and humidity-controlled and ultraviolet (UV)-filtered (yellow-light) cleanroom laboratories. However, other conditions of temperature, pressure and humidity, such as in a controlled environment, may be used but are not required.

In an embodiment, the deep ultraviolet light has a wavelength between 200 - 280 nm, preferably between 240 and 260 nm. The present inventors have found that these deep UV wavelengths have the desired effect of degrading the polystyrene at the surface. In an embodiment, the deep ultraviolet light has a wavelength between 193 and 254 nm, such as 254 nm.

In an embodiment, an ultraviolet crosslinker apparatus, sterilization equipment, a UVC-LED box comprising an array of LEDs or a UV laser (in non-ablating mode) is used to expose the substrate. The present method can be carried out using specialized UV sources and photomasks. However, to improve and simplify accessibility of the present inventive method, the present inventors have found that UV sterilization lamps and other UV sources can be used as well, which often employ low-pressure mercury lamps emitting UVC irradiation (100 to 300 nm range) and are commonly used in biological laboratories, for example in laminar flow hoods. In addition, UVC light emitting diodes (UVC-LEDs) that recently have also been incorporated in compact, portable sterilization devices aimed at household use are suitable for the present inventive method. Tests shown that even with short process times of 30 min DUV exposure and 30 seconds of wet chemical development, structures could be reproducibly fabricated on polystyrene substrates. The fact that many different types of UV sources may be used in the present method makes the present method extremely versatile and easy to use with standard equipment.

In an embodiment, the power of the radiation to which the substrate is exposed is from 0.1 mW/cm$^2$ to 100 mW/cm$^2$. The power is limited (upper limit) to the power which would cause direct ablation of the polystyrene at the surface of the substrate, which ablation is undesirable.

In an embodiment, in step b) the surface is exposed to a radiation dosage from 1 to 1000 J/cm$^2$. The inventors have found that this ranges provides good results.

In a second aspect, the invention relates to s polystyrene substrate having a structured surface obtained or obtainable by the method according to the first aspect of the invention. The structured surface is biologically compatible and can be used for cell and microtissue growth and experimentation.

The unprecedented simplicity of the present method nullifies the requirement for large and complex, expensive equipment and costly photoresists for lithography, thereby making the process easily accessible for non-specialists and researchers without access to micro- and nanofabrication clean rooms. The present method deploys tools existing or readily obtained in a standard biological laboratory, including polystyrene, chemicals for the developer solution, ("pocket") UV sources, permanent marker pens and laser or inkjet printers. The present method can be used in biological laboratories but also for technical applications where more sophisticated microstructures are required. A higher fidelity can be achieved by using polystyrene substrates with higher planarity, more sophisticated CQ masks and collimated UV sources. The present invention allows structured polystyrene substrate with low height variation to be obtained that are, for example, comparable to commercial silicon wafers having <1 $\mu$m height variation when measured across a length of (more than) 200 mm.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The scope of the present invention is defined by the appended claims. One or more of the objects of the invention are achieved by the appended claims.

**EXAMPLES**

The present invention is further elucidated based on the Examples described below which are illustrative only and not considered limiting to the present invention.

**Example 1: Preparation of microstructures using Chromium-quartz masks and a crosslinker UV apparatus**

*Material and methods*

A chromium-quartz (CQ) mask with microstructures was designed - with structures as small as 2 $\mu$m in size - by the present inventors and ordered from Deltamask B.V., the Netherlands. The mask was cut to the required dimensions so as to fit inside a single well of a polystyrene (PS) tissue culture-grade plastic (TCP) standard 6-well plate, being a 6-well Nunc™ Cell-Culture Treated (Nunclon™ delta surface treated, ThermoFisher Scientific, Massachusetts, USA). The mask was placed on the surface of said well. The plate was exposed to DUV irradiation using CX-2000 UV crosslinker for 360 min (or after 120 min exposure using Novascan PSD Series Digital UV device). As per the manufacturer, the CX-2000 UV crosslinker provides radiation with a power of 12.5 mW/cm$^2$ at 254 nm. For an exposure duration of 360 min (= 21600 sec), the radiation dose is: 1 mW/cm$^2$ = 1 mJ/(s·cm$^2$). 12.5 mW/cm$^2$ 21600 sec = 270000 mJ/cm$^2$ = 270 J/cm$^2$. After DUV exposure, the plate was developed using a developer solution consisting of 1:3 solution of xylene in isopropyl alcohol (IPA) with an amount of solution sufficient to cover the surface (approx. 2 mL). After development, the wells of the plate were rinsed with IPA twice and allowed to dry under constant air flow.

*Results*

Upon an exposure time ($t_{exp}$) of 360 min and a development time ($t_{dev}$) of 30 sec, various features including squares, lines and circles were reproduced on the substrate with feature sizes as low as 2 $\mu$m. Figure 1C shows a laser scanning microscope image showing different microstructures from a test design ranging from 1 to 50 $\mu$m feature size. Scale bar represents 500 $\mu$m. Further, alphanumeric entities were reproduced onto PS substrate. Figures 1D and E shows the text developed on the surface of the wells, Figure 1D shows the text ("MERLN GT LAB") as a depressed/embedded structure and Figure 1E as a raised/heightened structure. This is done by chancing the tone of the mask when going from 1D to 1E. Upon changing the tone of the mask, large portions of the exposed PS substrate were developed, while the unexposed regions (which appear as raised structures) were retained. Scale bars represent 100 $\mu$m. This example clearly shows that one or more aims of the present invention are obtained with the present method.

**Example 2: Preparation of microstructures using Chromium-quartz masks and a portable UV apparatus**

*Material and methods*

The same materials and method were used as in Example 1 except for the following. For the accessible, pocket, lithography process, a 59S UV sterilizer box S2 (Shenzhen UVLED Optical Technology Co. Ltd., Zhenzhen, China), also referred to as UVC-LED box, was used which consists of an array of 8 LEDs. When used in conjunction with this portable device, plates were irradiated for 30 min. As per the manufacturer, the device provides radiation with a power of 2.154 mW/cm$^2$ near the UVC-LED. For an exposure duration of 30 min (= 1800 sec), the radiation dose is: 2.154 mW/cm$^2$ * 1800 sec = 3877.2 mJ/cm$^2$ = 3.8772 J/cm$^2$.

*Results*

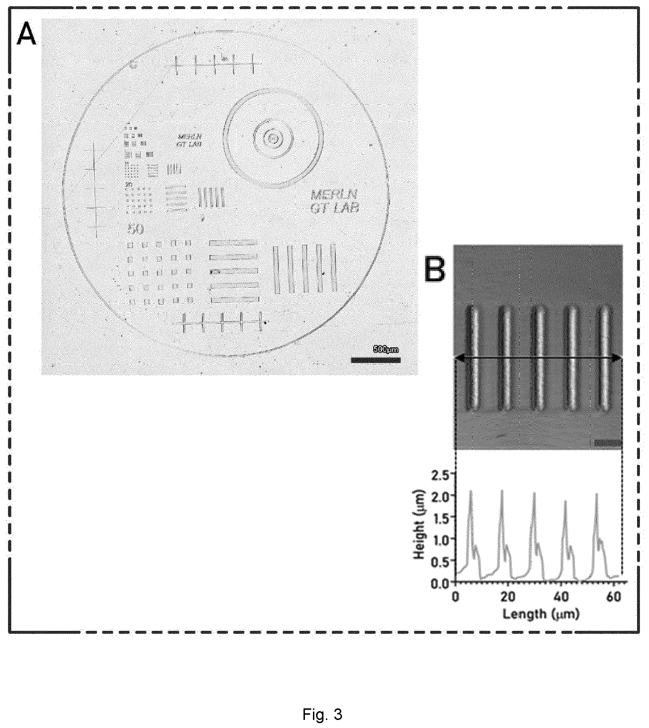

Despite using significantly short process parameters ($t_{exp}$ = 30 min; $t_{dev}$ = 30 sec), it was observed that the test microstructures were reproducibly fabricated on the substrate. Figure 3A (scale bar = 500 $\mu$m) shows the test structures fabricated, which are the same as in Figure 1C for example 1. Even for smaller structures like with 4 $\mu$m wide lines, the process enabled heights approaching 2 $\mu$m as can be observed from Figure 3B showing a laser scanning microscope image (Figure 3B (top), scale bar = 10 $\mu$m) and corresponding height variation (Figure 3B (bottom)) for 4 $\mu$m wide structures show heights approaching 2 $\mu$m could be obtained on a substrate using the pocket DUV source. This example shows that miniaturization of the experimental setup for direct DUV lithography using a "pocket-scale" DUV sterilization device was possible.

**Example 3: Preparation of microstructures using different brands of plates**

*Material and methods*

The same materials and method were used as in Example 1 except for the following. In order to validate that the structures can be fabricated using different brands of 6-well plates, 6-well Nunc™ Cell-Culture Treated (Nunclon™ delta surface treated, ThermoFisher Scientific, Massachusetts, USA) and 6-well tissue culture plates (surface non-treated, VWR, Radnor, USA) were tested by using CQ masks having microgrooves in three different patterns (A, B and C). Pattern A has transparent parallel lines with a width of 150 micrometer, which are 50 micrometers apart. Pattern B has transparent parallel lines with a width of 20 micrometer, which are 100 micrometers apart. Pattern C has transparent parallel lines with a width of 5 micrometer, which are 45 micrometers apart (all dimensions are edge to edge). For all experiments the exposure time ($t_{exp}$) was 360 min.

*Results*

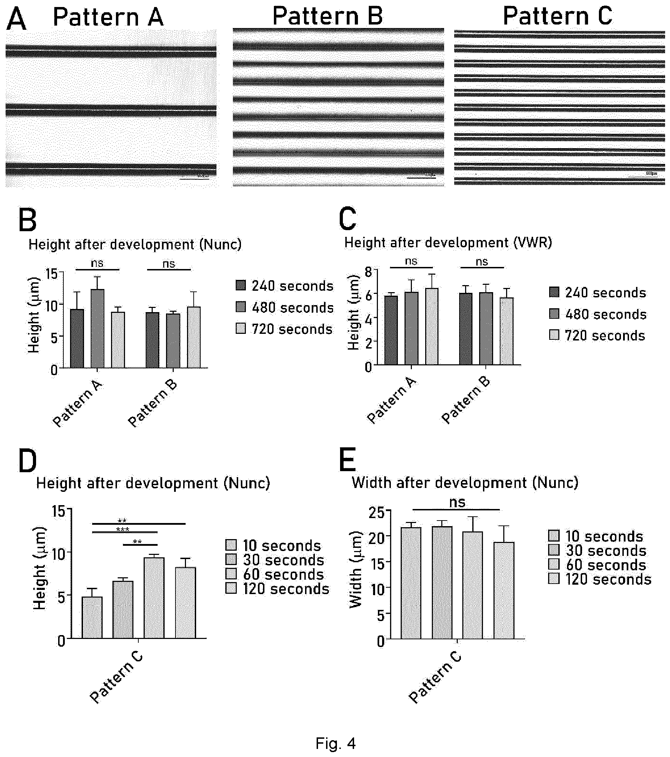

Figure 4A shows these different patterns (scale bars = 100 $\mu$m). Figure 4B shows the mean height difference between DUV unexposed regions and DUV exposed and developed regions in the wells. For pattern A (NUNC plates) this was 9.21 $\pm$ 2.6 $\mu$m and for pattern B this was 8.7 $\pm$ 0.74 $\mu$m after 4 min of development. Longer development times ($t_{dev}$ = 720 sec) of either type of well plates did not lead to a significant increase in the mean height difference. Figure 4C shows the mean height difference between DUV unexposed regions and DUV exposed and developed regions in the wells. For pattern A (VWR plates) this was 5.80$\pm$ 0.25 $\mu$m and for pattern B this was 6.04 $\pm$ 0.60 $\mu$m after 4 min of development. Thus both plates allow the preparation of microstructures although the depth varies. Figure 4D shows the mean height difference between DUV unexposed regions and DUV exposed and developed regions in the wells after development of pattern C in NUNC plates using different development times of 10 seconds, 30 seconds, 60 seconds and 120 seconds, showing that an optimal height is observed after 60 seconds. Figure 4E shows the width at base of the microgrooves showing no significant change for different development times, the width ranges between 18.83 and 20.90 $\mu$m.

**Example 4: Preparation of microstructures using an permanent pen ink masks and a portable UV apparatus**

*Material and methods*

The same materials and method were used as in Example 1 except for the following. Permanent markers were used to write patterns directly on a substrate, which was then irradiated using the UVC-LED sterilization box.

*Results*

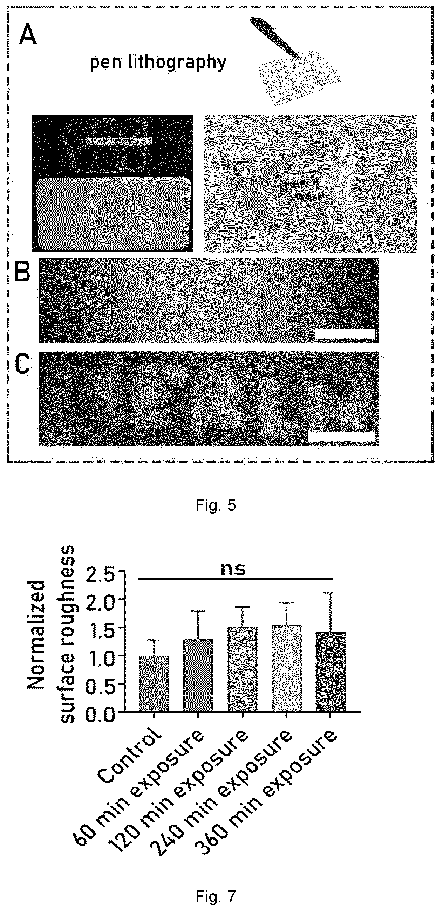

Figure 5A shows that ink can be directly deposited on the polystyrene surface using a permanent marker pen to create a temporal masking layer. While nonirradiated masked substrates, on which a text ("MERLN") was written with a permanent marker pen, did not show any pattern formation after $t_{dev}$ = 240 sec (Figure 5B), the DUV-irradiated ($t_{exp}$ = 30 min) and developed ($t_{dev}$ = 240 sec) substrates, on which the same text was written with a permanent marker pen, showed a clear pattern formation (Figure 5C) with more than 2 $\mu$m height difference between exposed and unexposed regions. This clearly shows the effect of using a permanent marker pen as a mask. The scale bar in 5B and 5C is 2000 $\mu$m.

**Example 5: Preparation of microstructures using printer-based masks and either a crosslinker or portable UV apparatus**

*Material and methods*

The same materials and method were used as in Example 1 except for the following. An imprinted toner on a substrate was used as a mask for DUV lithography. Images were first converted to stencil patterns. Any image processing software could be used for this purpose. The processed patterns were arranged on an A4-sized page using Microsoft Word (version 2019) and printed either on an HP high gloss photopaper (280 g/m$^2$) or using the backing paper of Avery Zweckform white labels (L4773-20) using the default settings on a Canon C475iZ officer printer. The printed patterns were cut at the edges and transferred to the substrate. After finishing the imprinting, the substrate was exposed to DUV using either CX-2000 or 59S UV sterilizer box S2. The imprinted substrate containing the pattern overlay was exposed to DUV followed by removal of the ink and development: $t_{exp}$ = 180 min using the CX-2000 DUV device; $t_{dev}$ = 240 sec).

*Results*

Figure 2 discussed above shows the results of this example. The patterns were well reproduced on the substrate after transfer from the photopaper as seen after DUV exposure and subsequent development. The patterns were not optically visible upon removal of ink using an alcohol (here: IPA) before development using an organic solvent. Optical images and corresponding height maps showed that the height difference between exposed and unexposed regions increased from less than 0.450 $\mu$m before development ($t_{dev}$ = 0 sec) to about 3.5 $\mu$m after development ($t_{dev}$ = 240 sec). The use of printed ink as a direct mask is also compatible with the handheld UVC-LED sterilization box; this combination was used to achieve a height difference of more than 2 $\mu$m between the exposed and unexposed regions after 30 min of exposure and 240 sec of development.

**Example 6: UV-Vis spectroscopy to show effect of exposure and development time**

In order to confirm that polystyrene photodegradation in substrates upon DUV irradiation occurs in a dose-dependent manner, the absorptance in the 280 - 400 nm range was measured using UV-VIS spectroscopy.

*Material and methods*

The same materials and method were used as in Example 1 except for the following. The optical characteristics of plates were measured by a UV-VIS spectrophotometer (Agilent Cary 60). The spectra of the plates were collected by scanning the wavelengths in the 200-800 nm region at a scan rate of 24000 nm/min. Four wells at each corner of the plate were measured giving an N = 4 for each plate. Each spectrum was produced in reflectance mode and the %Transmittance (T) was calculated using the equation A = -log(%T), where A is absorbance. The yellowing index (YI, see equation 3 from the publication K. G. d. C. Monsores, A. O. d. Silva, S. d. S. A. Oliveira, J. G. P. Rodrigues, R. P. Weber, Influence of ultraviolet radiation on polymethylmethacrylate (PMMA). Journal of Materials Research and Technology 8, 3713-3718 (2019) was calculated from the resulting data at 420, 580 and 680 nm wavelengths:

$$YI\ (percent) = \frac{(Tp-Te)_{420}-(Tp-Te)_{680}}{(Tp)_{580}} * 100$$

(Equation 1).

Tp = Transmittance of pristine sample; Te = Transmittance of the DUV exposed (and/or developed) sample.

*Results - exposure time*

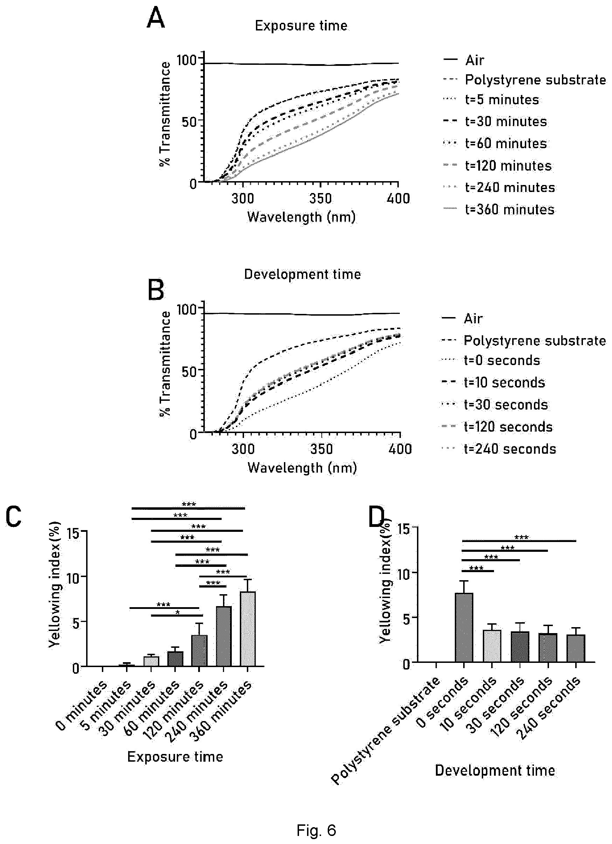

Upon exposure to DUV irradiation for different durations (0-360 min) using a desktop CX-2000 DUV device, an increase in absorptance (and hence decrease in transmittance) of the samples was found with increased exposure time when measured in the 280 to 400 nm range (Figure 6A). Please note that in this drawing the curve for the polystyrene substrate and the curve for a an exposure time of 5 minutes (t=5) overlap.

The increase in said absorptance was accompanied by progressive yellowing of the substrate , credited to the increase in conjugated bonds in the polystyrene backbone. The yellowing of the substrate after DUV exposure was quantified using the yellowing index (YI, in percent) (Equation 1, as mentioned above). The mean YI increased with increased $t_{exp}$: The mean YI was 0.16% with $t_{exp}$ = 5 min, which attained a maximum of 8.32% at $t_{exp}$ = 360 min (Figure

6C, N≥3).

*Results - development time*

After DUV exposure for 360 min, the substrate was developed for different durations (0-240 sec), using the aforementioned xylene-IPA solution. It was found that the absorptance initially increased upon no development (0 sec) compared to control, pristine substrate (Figure 6B, shown as average of N≥3 samples). Please note that in this drawing the curve for an exposure time of 120 seconds (t=120) and the curve for an exposure time of 240 seconds (t=240) fully overlap; these partly overlap with the curve for an exposure time of 30 seconds (t=30).

It was further observed that using $t_{dev}$ = 10 sec led to a significant decrease in the absorptance. Increasing the development time to more than 10 sec led to similar absorptance curves without any changes. Upon increasing $t_{dev}$, the absorptance never reached the original values corresponding to the control, pristine substrate (Figure 6B). The YI of developed substrate significantly decreased (p<0.001) compared to DUV exposed and undeveloped substrate, and this decrease corresponded with increase in $t_{dev}$: average YI values were of 7.69% before development, 3.61 after development of TCP with $t_{dev}$ = 10 sec, and 3.08% after development of substrate with $t_{dev}$ = 240 sec (Figure 6D, N≥3).These results indicate that the exposure process led to photodegradation of the substrate while the development process led to dissolution and removal of the degraded polystyrene.

**Example 7: Measurement of surface structures by profilometer and surface roughness measurements**

*Material and methods*

The same materials and method were used as in Example 1 except for the following. The surface profile and height/depth of the structures were measured using a Keyence VK-X250K confocal laser scanning microscope (Keyence, Osaka, Japan) with either a 10x, 20x or 50x objective after irradiation and development. For visual depiction, the stitched 2D height map images with automatically optimized upper and lower height data limits were exported from the Keyence VK-X series multifile analyzer software (1.3.1.120). The difference in height of each point as compared to the arithmetical mean of the surface, which is described as the arithmetical mean height, was also measured using the profilometer and used as a measure of surface roughness.

*Results*

In Figure 7 is shown the effect of increasing the DUV exposure time from 60 min to 360 min on the surface roughness. The results clearly show that microfabrication did not lead to a significant increase in the surface roughness of TCP substrates after $t_{dev}$ = 240 sec. Although the mean value after the 360 min exposure is higher compared to the control, i.e. pristine TCP, the values show no overall statistical significance (all values were normalized to the control; ns = no statistical significance; N≥3).

**Example 8: Cell culture using the structured surfaces of the present invention**

*Material and methods*

*HUVECs - culturing and immunostaining*

For cell experiments, human umbilical vein endothelial cells (HUVECs) (Gibco™ C0035C) and E14Tg2A mouse embryonic stem cells (mESCs) (3) (ECACC 08021401) were used. HUVECs were cultured in flasks coated with 1% gelatin while mESCs were cultured in flasks coated with 0.1% gelatin. HUVECs were cultured in Medium 200 (Gibco, ThermoFisher Scientific) with the addition of low serum growth supplement (Gibco, ThermoFisher Scientific). mESCs were cultured in GMEM BHK-21 medium with added leukemia inhibitory factor (LIF), MEM non-essential amino acids, sodium pyruvate, GlutaMax, β-Mercaptoethanol and fetal calf serum (FCS). The cells were cultured in an incubator maintained at 5% $CO_2$ and 37 °C. For all experiments, the 6-well Nunc™ Cell-Culture Treated (Nunclon™ delta surface treated, ThermoFisher Scientific, Massachusetts, USA) were used prepared according to Example 3 with pattern C. Before the experiments, the (developed) wells were rinsed with Phosphate Buffered Saline (PBS) twice followed by sterilization with 70% ethanol for 15 min. After another rinse with PBS, 0.1% gelatin was put into each well for at least 30 min. Prior to the cell seeding, the gelatin solution was aspirated and the wells were filled with cell culture medium.

For staining HUVECs with Hoechst and phalloidin, the wells were first washed with PBS and incubated with 4% formaldehyde for 30 min. The samples were then washed with PBS thrice followed by incubation in a permeabilization and blocking buffer (consisting of 0.25% TritonX-100, 50% Cas-Block (ThermoFisher Scientific) and 1% BSA in Dulbecco's Phosphate Buffered Saline (DPBS)). The wells were then washed with DPBS followed by staining with Hoechst 33342 (ThermoFisher Scientific; 1:200 in PBS; 1 mg/mL stock) or Alexa Fluor 568 or 488 Phalloidin (ThermoFisher Scientific; 1:400 in PBS; 66 $\mu$M stock) for a minimum of 30 min. The wells were then washed thrice and imaged in PBS.

*PC-12 spheroids - culturing and immunostaining*

For PC-12 spheroids (ACC159, DSMZ-German Collection of Microorganisms and Cell Cultures GmbH) neural differentiation, the wells of 6-well Nunc™ Cell-Culture Treated (Nunclon™ delta surface treated, ThermoFisher Scientific, Massachusetts, USA)were sterilized with 70% ethanol for 30 min followed by rinsing with sterile water and poly-D-lysine coating (PDL, 10 $\mu$g/mL; P6407, Sigma-Aldrich) mixed with laminin (2 $\mu$g/ml; Cultrex 3400-010-02, R&D Systems) which were dissolved in PBS (D8537, Sigma-Aldrich). The plates were incubated at 37 °C in an incubator overnight to facilitate cell attachment. After incubation, the coating solution was removed and wells were washed thrice with PBS prior to PC-12 seeding. The PC-12 spheroids were exposed to differentiation medium (99% RPMI, 61870-010, Gibco), 1% horse serum (H1270, Sigma-Aldrich), and 100 ng/mL nerve growth factor (NGF; N1408, Sigma-Aldrich) and differentiated for 12 days in an incubator at 37 °C and 5% $CO_2$.

For PC-12 spheroids, the neurites were stained with pill-tubulin (chicken anti-pill-tubulin, Novus Biologicals, NB100-1612) followed by secondary antibody (goat anti-chicken AF647-conjugated, Thermo Fisher Scientific, 10739004). Briefly, the samples were fixed with 4% formaldehyde for 30 min followed by permeabilization (0.1% TritonX-100) and blocking (Cas-Block) for 4 hour. Primary antibody ($\beta$III-tubulin prepared 1:1000 in Cas-Block with 0.1% TritonX-100) was performed overnight, followed by a PBS wash and secondary antibody incubation (goat anti-chicken AF647-conjugated, 1:500 in CasBlock) for 1 hour. Followed by this, the samples were washed with PBS followed by Hoechst 33342 nuclear staining (1:200 in PBS) for 30 min. Lastly, the samples were washed with PBS before imaging.

*Microscopy analysis*

Fluorescence imaging was performed using a Nikon eclipse Ti-S inverted microscope. Images were analyzed using either Nikon NIS Elements software or FIJI (4). To increase the visibility of the signal, the Look-up tables were modified where required. For images showing 3D stack (Hoechst and phalloidin) staining in HUVECs, image deconvolution was performed using Nikon NIS software. The angle of nuclear alignment, which represents the angle of the major elliptical axis of nucleus with respect to the microgrooves (0°), was calculated using FIJI. All angles were finally depicted on a 0° to 90° scale. In total, more than 80 nuclei were analyzed for each condition (micropatterned and control) spread across at least three independent measurements.

The angle of alignment for neurite outgrowth with respect to the microgrooves was calculated in FIJI by first drawing three concentric circles (with radius r, 2.5*r and 4*r) with the innermost circle with radius r fitting the spheroid outline. The alignment of the neurites between the outermost circles (with radius 2.5*r and 4*r) were then obtained by drawing a straight line along the points of neurite contact between the two circles (with radius 2.5*r and 4*r) and depicted on a 0° to 90° scale with the microgrooves forming the reference angle (0°). For control samples, the measurement was performed relative to an arbitrary reference. Measurement was not performed on neurites that: i) divided (split) indistinctly, ii) did not come in contact with the outermost circle (4*r) or iii) had an undistinguishable growth profile. In total, more than 35 neuronal outgrowths for each condition (micropatterned or control) spread across at least three independent samples were analyzed.

*Time-lapse imaging*

Live cell microscopy was performed using Nikon eclipse Ti-S microscope with Okolab boldline incubator which was used to maintain the sample at 37 °C with 51% relative humidity and 5% $CO_2$. The incubator was started 1 hour prior to the start of the experiment to equilibrate the conditions. For time-lapse experiments with HUVECs, images were acquired every 15 min for 3 hours. Cell migration in HUVECs was analyzed by performing manual cell tracking using the ImageJ plugin MTrackJ (5). The resulting data were exported to the Chemotaxis and Migration tool (Ibidi) which was used for data analysis and plotting. The migration pattern of cells in the micropattern was compared to the control sample, which were the regions in the same well without any micropatterns. Migration of at least 50 cells from a well of a 6-well plate were analyzed for either the micropatterned or the control region. For time-lapse experiments of neurite outgrowth in PC-12 spheroids, images were acquired every 30 min for 19 hours.

*Results*

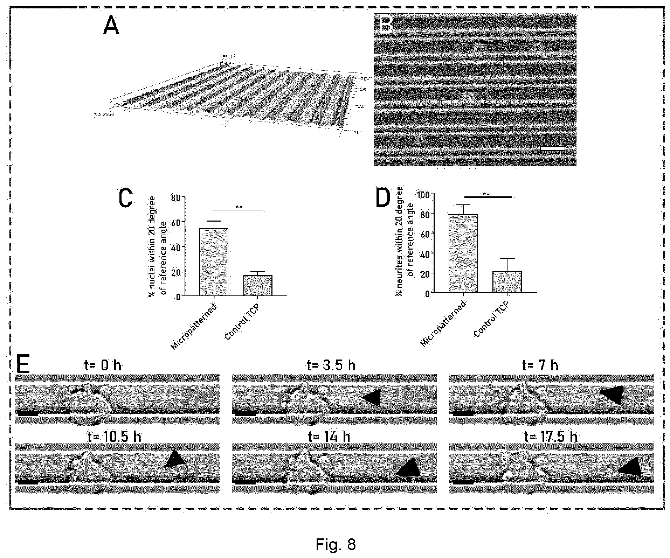

Nuclear and actin staining of the cells 2 days post-seeding showed the cells adhered in an oriented manner to micropattern C Figure 8 shows that the structures of pattern C can be used to control and manipulate cell migration, orientation and outgrowth of cells

Analysis of the orientation and migration characteristics of HUVECs cultured in these microstructures showed that when the cells were seeded onto the microstructures, single cells appeared to collect in the microgrooves within a few minutes of cell seeding. Figure 8A is a height map of microgrooves resulting from pattern C mask. Figure 8B shows that HUVEC cells were collected in the microgrooves within a few minutes after cell seeding (scale bar = 100 $\mu$m).

Upon tracking cell migration within the microstructures every 15 min for 3 hours, it was found that the cells in the microgrooves predominantly migrated in a more oriented and directed manner compared to the random migration of cells on non-patterned surface (results from at least 50 cells for each condition). Quantification of nuclei orientation, which has been a widely used parameter for cells seeded on microgrooves and also has been previously shown to correspond with the microgroove orientation, demonstrated that cells in control samples (pristine substrate) showed no nuclei orientation along a certain angle while cells cultured on pattern C microgrooves showed a clear nuclei orientation. Figure 8C shows that significantly more nuclei (~55%) from cells cultured on micropatterned surface were oriented within 20° relative to the microgrooves (0°) while only 17% nuclei from the non-patterned control substrate were in this range relative to an arbitrary reference (more than 80 nuclei analyzed across N$\geq$3; ** denotes p<0.01). Figure 8D shows that more than 75% of neurites in patterned substrates were aligned within 20° relative to the microgrooves (0°) while neurites from the non-patterned control substrate were randomly oriented with less than 25% being in this range relative to an arbitrary reference. Data show merged values of more than 35 neuronal outgrowths for each condition spread across N$\geq$3; ** denotes p<0.01. Time-lapse imaging of the PC-12 spheroids for 19 hours starting from the initiation of the neural outgrowth (7 days post-seeding) revealed that the neurites were constrained within the microgrooves (Figure 8E).

**Example 9: Microthermoforming of polystyrene films having the structured surfaces of the present invention**

*Material and methods*

Microthermoforming of polystyrene film was performed using a custom-designed mold microfabricated in brass plates (MS58) and designed using Autodesk Inventor. The mold consisted of 800 $\mu$m diameter (designed dimension) microcavities arranged in an array (in a honeycomb-like manner) for a total of 77 microcavities and was manufactured using precision-micromilling by i-sys Mikro und Feinwerktechnik GmbH (Germany). Thin polystyrene films (-300 $\mu$m) were first exposed to DUV irradiation ($t_{exp}$ = 360 min) according to Example 3, pattern C, followed by the forming process, which was done using a polymer-assisted forming variation of microthermoforming.

*Results*

The resulting microcavity arrays were developed ($t_{dev}$ = 60 sec) leading to patterned microcavity arrays which were created using the pattern C mask.

**Claims**

1. Method for producing structures in a polystyrene substrate, said method comprising the steps of:

    a) providing a polystyrene substrate having a surface;
    b) partially exposing the surface of said polystyrene substrate to deep ultraviolet light radiation having a wavelength of 100 nm - 300 nm to selectively photodegrade polystyrene at the surface of the exposed areas; and
    c) removing the degraded polystyrene from the surface of the exposed areas by wet chemical development using a chemical developer solution comprising an organic solvent in an alcohol in an amount of 1:10 to 1:1 to produce said structures.

2. Method according to claim 1, wherein the polystyrene substrate provided in step a) has a thickness of at least 1 micrometer.

3. Method according to claim 1 or 2, wherein the polystyrene substrate is a solid self-supporting material or a polystyrene film.

4. Method according to any one of the preceding claims, wherein as a substrate polystyrene cell culture ware is used, preferably selected from the group consisting of a Petri dish, a tissue culture treated or non-treated multi-well cell culture plate, and a microtiter plate.

5. Method according to any one of the preceding claims, wherein step b) comprising the following sub steps:

b-1) applying a photomask to the surface of the polystyrene substrate to be structured;
b-2) exposing the surface of said polystyrene substrate through said photomask to deep ultraviolet light having a wavelength of 100 nm - 300 nm to selectively degrade polystyrene at the surface of the exposed areas;
b-3) removing of said photomask from said exposed surface of the polystyrene substrate.

6. Method according to any one of the preceding claims, wherein the photomask is selected from the group consisting of a shadow photomask with non-absorbing and absorbing regions, a Chromium-quartz (CQ) photomask, and an ink photomask.

7. Method according to claim 6, wherein the photomask is an ink photomask prepared by transferring toner and/or ink from a printed surface to the surface to be structured.

8. Method according to any one of the preceding claims, wherein step c) comprises the sub steps of:

c-1) applying the chemical developer to said surface of said substrate, said developer preferably being xylene in IPA, having a xylene to IPA ratio of 1:10 - 1:1, preferably 1:3, to remove degraded polystyrene; and
c-2) rinsing said surface of said substrate provided with structures with a solvent, preferably IPA, to clean said surface.

9. Method according to any one of the preceding claims, wherein the exposure of step b) is carried out for 10 to 500 minutes and/or wherein the development of step c) is carried out from 1 to 1000 seconds.

10. Method according to any one of the preceding claims, wherein the structures formed are nanostructures and/or microstructures, preferably having a width no less than 100 nanometer and/or preferably the structures formed have a depth from 1 to 20 micrometer.

11. Method according to any one of the preceding claims, wherein as a substrate a polystyrene film is used and wherein an additional step d) is present, comprising the thermoforming of said structured polystyrene film.

12. Method according to any one of the preceding claims, wherein the method is carried out at ambient conditions of temperature and pressure.

13. Method according to any one of the preceding claims, wherein the deep ultraviolet light has a wavelength between 200 - 280 nm, preferably between 240 and 260 nm.

14. Method according to any one the preceding claims, wherein the organic solvent of the developer solution is selected from the group consisting of xylene, acetone, toluene, dimethyl sulfoxide, and dichloromethane and/or wherein the alcohol in the developer solution is isopropyl alcohol (IPA).

15. Polystyrene substrate having a structured surface obtainable by the method according to any one of claims 1-14.

Fig. 1

Fig. 2

Fig. 3

Fig. 4

Fig. 5

Fig. 7

Fig. 6

Fig. 8

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PALACIOS MARTA ET AL: "Constructing Robust and Functional Micropatterns on Polystyrene Surfaces by Using Deep UV Irradiation", LANGMUIR, vol. 29, no. 8, 26 February 2013 (2013-02-26), pages 2756-2763, XP055890576, US ISSN: 0743-7463, DOI: 10.1021/la304931x Retrieved from the Internet: URL:https://pubs.acs.org/doi/pdf/10.1021/la304931x> * Experimental section; page 2757 * ----- | 1-15 | INV. G03F7/039 G03F7/32 |
| T | PACE E ET AL: "An innovative photochemical facility at DANE-L", JOURNAL OF PHYSICS: CONFERENCE SERIES, INSTITUTE OF PHYSICS PUBLISHING, BRISTOL, GB, vol. 425, no. 7, 22 March 2013 (2013-03-22), page 72024, XP020243290, ISSN: 1742-6596, DOI: 10.1088/1742-6596/425/7/072024 * figure 2 * ----- | | TECHNICAL FIELDS SEARCHED (IPC) G03F C12N |

-/--

The present search report has been drawn up for all claims

| Place of search | Date of completion of the search | Examiner |
|---|---|---|
| Munich | 14 February 2022 | Le Masson, Nicolas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**page 1 of 2**

## EUROPEAN SEARCH REPORT

Europäisches
Patentamt

European
Patent Office

Office européen
des brevets

**Application Number**

EP 21 19 4755

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Mohamma Mohammad Ali: "N SML resist processing for high-aspect-ratio and high-sensitivity electron beam lithography", Nanolithography, 27 March 2013 (2013-03-27), XP055890867, Retrieved from the Internet: URL:https://www.ncbi.nlm.nih.gov/pmc/artic les/PMC3617037/pdf/1556-276X-8-139.pdf [retrieved on 2022-02-12] * abstract * | 1-15 | |
| X | PFLEGING W. ET AL: "Patterning of polystyrene by UV-laser radiation for the fabrication of devices for patch clamping", PROCEEDINGS OF SPIE, vol. 6880, 7 February 2008 (2008-02-07), page 68800D, XP055890561, 1000 20th St. Bellingham WA 98225-6705 USA ISSN: 0277-786X, DOI: 10.1117/12.763149 ISBN: 978-1-5106-4548-6 | 15 | |
| A | * abstract * * figure 1 * | 1-14 | TECHNICAL FIELDS SEARCHED (IPC) |
| X | KNUDSEN DANIEL ET AL: "Creating microstructures on silicon wafers using UV-crosslinked polystyrene thin films", POLYMER ENGINEERING AND SCIENCE, vol. 49, no. 5, 1 May 2009 (2009-05-01), pages 945-948, XP055890573, US ISSN: 0032-3888, DOI: 10.1002/pen.21272 * Scheme 1 * | 15 | |

The present search report has been drawn up for all claims

| Place of search | Date of completion of the search | Examiner |
|---|---|---|
| Munich | 14 February 2022 | Le Masson, Nicolas |

EPO FORM 1503 03.82 (P04C01)

page 2 of 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **PALACIOS et al.** *Langmuir,* 2013, vol. 29, 2756-2763

- **K. G. D. C. MONSORES ; A. O. D. SILVA ; S. D. S. A. OLIVEIRA ; J. G. P. RODRIGUES ; R. P. WEBER.** Influence of ultraviolet radiation on polymethylmethacrylate (PMMA). *Journal of Materials Research and Technology,* 2019, vol. 8, 3713-3718